# FASCICULE DE BREVET EUROPEEN

(11) **EP 3 182 538 B1**
(45) Date de publication et mention de la délivrance du brevet: **03.02.2021**
(21) Numéro de dépôt: 16203844.2
(22) Date de dépôt: 13.12.2016
(51) Int. Cl.: H02B 13/025

(54) **DISPOSITIF DE REFROIDISSEMENT DE GAZ CHAUDS DANS UN APPAREILLAGE HAUTE TENSION**
KÜHLVORRICHTUNG FÜR HEISSE GASE IN EINEM HOCHSPANNUNGSGERÄT
DEVICE FOR COOLING HOT GASES IN A HIGH-VOLTAGE APPARATUS

(30) Priorité: 15.12.2015 FR 1562418
(43) Date de publication de la demande: 21.06.2017
(73) Titulaire: Schneider Electric Industries SAS, 92500 Rueil-Malmaison (FR)
(72) Inventeur: CORMENIER, Thierry, 38050 Grenoble Cedex 9 (FR); DOUCHIN, Jérôme, 38050 Grenoble Cedex 9 (FR)
(74) Mandataire: Brevalex

(56) Documents cités:
- FR-A- 1 441 240
- US-A- 4 180 177
- US-A1- 2010 170 876

## Description

### DOMAINE TECHNIQUE

L'invention concerne la sécurité des personnes exploitant un appareillage haute tension sous enveloppe métallique ou un poste préfabriqué haute tension/basse tension et concerne plus spécifiquement un dispositif de refroidissement de gaz chauds générés par un défaut d'arc interne. Ces dispositifs de refroidissement peuvent, entre autres, être utilisés pour réussir les essais des normes IEC 62271-200 et IEC 62271-202, en particulier lorsque l'appareillage haute tension est installé dans un espace réduit. Ils peuvent également être utilisés pour minimiser des risques non couverts par ces normes, comme la montée en pression dans la salle électrique, ou bien encore le risque de démarrer un incendie.

Dans la suite de la description, le terme Haute Tension correspond à une tension alternative supérieure à 1000 Volts. Néanmoins, un tel dispositif pourrait également être utilisé pour des appareillages basse tension.

### ÉTAT DE LA TECHNIQUE ANTÉRIEURE

Un des modes de défaillance connu dans les appareillages haute tension sous enveloppe métallique est l'arc interne, qui est un court-circuit circulant dans l'air ou dans le SF6 (Hexafluorure de soufre) entre conducteurs, ou entre un conducteur et la masse. L'arc est un plasma de gaz ionisé, dont la température d'équilibre est très élevée. Il est dit «interne» car situé à l'intérieur d'une enveloppe métallique. En plus des effets classiques d'un court-circuit (échauffement des conducteurs, effets électromagnétiques), l'arc interne se caractérise par une quantité d'énergie énorme transmise au fluide (gaz). L'énergie dissipée, allant jusqu'à plusieurs dizaines de mégajoules sur une seconde, génère des effets thermiques et des effets de pression qui provoquent une expulsion abondante de gaz chauds. Ceci crée un risque pour l'opérateur lors de la détente de ces gaz dans des volumes finis insuffisants ou lorsque ces gaz traversent une zone d'exploitation. Les volumes finis doivent s'entendre par opposition à des volumes infinis, lorsque la détente et l'évacuation des gaz se font directement vers l'extérieur ou vers un compartiment fortement ventilé de poste de transformation comme un local transformateur, sans passer par la zone d'exploitation de l'appareillage.

Notons que dans certains cas, les gaz sont évacués de la salle électrique vers l'air libre, à l'extérieur du bâtiment, par un conduit qui s'apparente à une cheminée. Dans d'autres cas, les gaz sont déchargés directement à l'intérieur de la salle électrique, par un orifice situé sur des faces de l'enveloppe métallique non accessibles aux opérateurs, le plus souvent le toit ou la face arrière de l'enveloppe. Lorsque l'arc interne survient dans l'enveloppe métallique, la pression augmente brutalement dans le compartiment en défaut. La vitesse des gaz évacués de l'enveloppe est très élevée, de sorte que le flux de gaz chaud peut rebondir contre le plafond et les parois latérales de la salle électrique constituant ainsi un danger pour les opérateurs qui s'y trouvent. Pour limiter la vitesse du flux de ces gaz chauds et en contrôler la direction, les solutions de l'art antérieur utilisent un refroidisseur tampon, installé au-dessus du compartiment, et constitué de filtres métalliques de type ailettes verticales ou horizontales, de grillages superposés ou de filtre de refroidissements constitués par un assemblage de roche volcanique de type pouzzolane.

Un inconvénient de ces refroidisseurs provient du fait que, d'une part, les refroidisseurs à base de pouzzolane présentent peu de critères de reproductibilité, et sont générateurs de poussières qui peuvent avoir un impact sur le vieillissement diélectrique, et d'autre part, les filtres métalliques ont une capacité de refroidissement limitée lorsqu'ils sont simplement réalisés à partir de tôles perforées, ou de grillages métalliques empilés.

Le document US 4 180 177 A décrit un dispositif d'évacuation comportant une cavité destiné à recevoir un appareil électrique, cette cavité étant munie d'une ouverture d'évacuation s'étendant de l'intérieur vers l'extérieur, un coup-flamme agencé sur ladite ouverture pour arrêter une éventuelle propagation de flamme en cas d'explosion dans la cavité tout en permettant l'évacuation de gaz à travers l'ouverture à une pression suffisante pour empêcher une accumulation de pression dans la cavité.

Le document US 2010/170876 A1 divulgue un disjoncteur ayant au moins un boîtier ayant une ouverture, et au moins une paire de contacts situés dans le boîtier, les contacts de la paire de contacts étant mobiles les uns par rapport aux autres pour ouvrir et fermer un circuit. Une mousse métallique à pores ouverts (20) isolée électriquement des éléments conducteurs du disjoncteur (I) est interposée entre au moins une des paires de contacts et le boîtier.

Le document FR 1 441 240 décrit un disjoncteur à gaz blindé comprenant une enveloppe métallique dans laquelle est disposé de façon isolée un dispositif de contact entouré d'une chambre de coupure remplie ou remplissable de gaz comprimé.

Un but de l'invention est de pallier aux inconvénients de l'art antérieur, décrits ci-dessus.

### EXPOSÉ DE L'INVENTION

Ce but est atteint au moyen d'un dispositif de refroidissement de gaz chauds générés par un arc interne dans un appareillage haute tension sous enveloppe métallique.

Le dispositif selon l'invention, comporte un filtre de refroidissement en mousse métallique ayant une structure alvéolaire de dimensions variables à couches superposées et reproductibles, appelée communément structure en nid d'abeille, comportant des alvéoles reliées de sorte à présenter des ouvertures dans toutes les directions.

Dans un premier mode de réalisation, ledit filtre en mousse métallique comporte des alvéoles sphériques reliées de manière à présenter des ouvertures dans toutes les directions.

Dans un deuxième mode de réalisation, le filtre en mousse métallique comporte des alvéoles formant des mailles hexaédriques.

Préférentiellement, le diamètre desdites alvéoles hexaédriques se situe entre 1 et 4 cm.

Dans un troisième mode de réalisation, le filtre en mousse métallique comporte des alvéoles formant des mailles carrées.

Dans les différents modes de réalisation, le filtre de refroidissement est réalisé en aluminium ou en fonte.

L'aluminium présente en effet une bonne résistance à la corrosion et la fonte représente une solution peu onéreuse. D'autres métaux seraient également utilisables.

### BRÈVE DESCRIPTION DES DESSINS

D'autres caractéristiques et avantages de l'invention ressortiront de la description qui va suivre, prise à titre d'exemple non limitatif, en référence aux figures annexées dans lesquelles:
- la figure 1 illustre schématiquement une vue de dessus d'une alvéole d'un filtre de refroidissement dans un mode préféré de réalisation selon l'invention ;
- la figure 2 illustre schématiquement plusieurs vues latérales de l'alvéole de la figure 1 ;
- la figure 3 illustre schématiquement une vue en trois dimensions d'un assemblage de plusieurs alvéoles de la figure 1 ;
- la figure 4 montre une vue partielle d'un exemple de réalisation d'un filtre de refroidissement équipant un dispositif de refroidissement constitué par l'assemblage de la figure 3 ;
- les figures 5 à 7 représentent trois possibilités d'installation d'un filtre de refroidissement dans un appareillage haute tension sous enveloppe métallique ou un poste préfabriqué haute tension / basse tension.

### EXPOSÉ DÉTAILLÉ DE MODES DE RÉALISATION PARTICULIERS

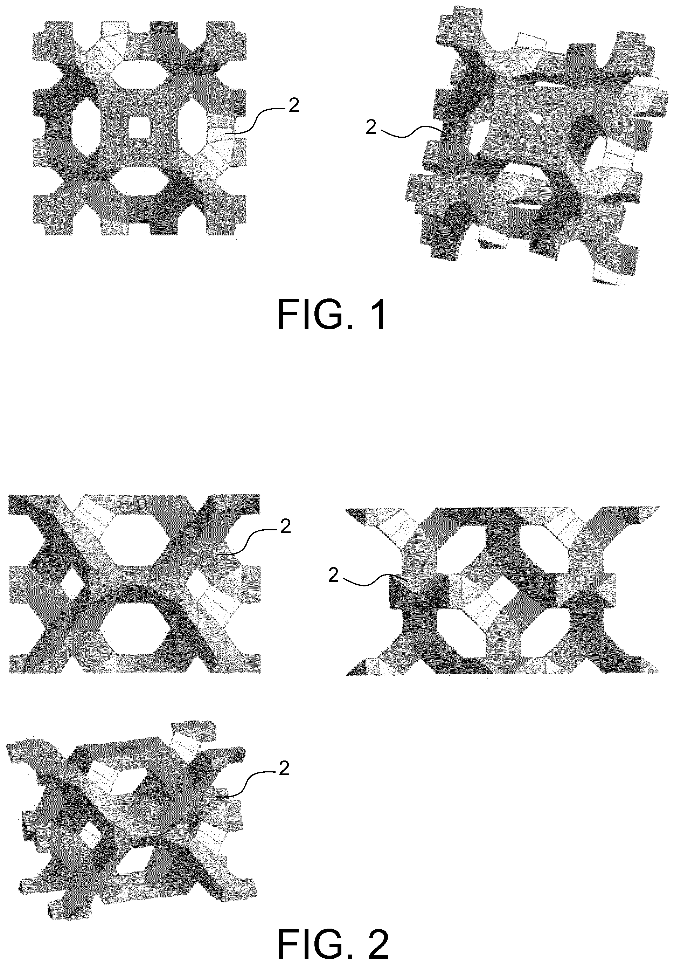

Les figures 1 et 2 représentent schématiquement, respectivement une vue de dessus et une vue latérale, d'une alvéole hexaédrique 2 pour fabriquer un filtre de refroidissement en mousse métallique, en aluminium ou en fonte par exemple, destiné à équiper une enveloppe métallique contenant un appareillage de commutation HT. Le filtre de refroidissement en mousse métallique peut également être installé entre deux volumes de détente dans un poste préfabriqué haute tension/basse tension ou une salle électrique préfabriquée.

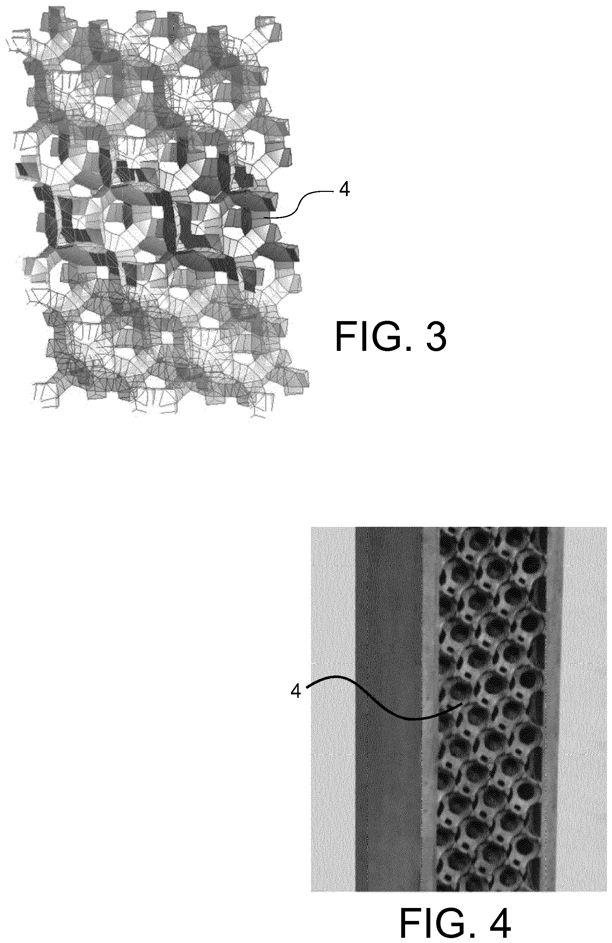

La figure 3 représente une structure en nid d'abeille maillée en 3D obtenue par assemblage de six alvéoles 2. Comme on peut le voir sur cette figure 3, les alvéoles 2 sont assemblées de sorte que chacune d'elles présente des ouvertures dans toutes les directions de l'espace. Cette structure favorise une augmentation des turbulences dans les alvéoles, augmentant le transfert de chaleur dans des conditions d'arc interne. Elle assure en même temps une porosité globale élevée, limitant sensiblement l'augmentation de la pression interne en amont du filtre. Le gain sur l'écoulement (vitesse, température,..) s'obtient donc sans impact notable sur l'appareillage.

La figure 4 représente un exemple de filtre de refroidissement 4 équipant un dispositif obtenu par le mode d'assemblage illustré par la figure 3 destiné à être installé dans une cellule sous enveloppe métallique contenant un appareillage haute tension. Ce filtre de refroidissement a une porosité élevée qui favorise une augmentation des turbulences dans les alvéoles et une augmentation des transferts de chaleur dans des conditions d'arc interne.

Préférentiellement, le diamètre des alvéoles 2 se situe entre 1 et 4 cm et l'épaisseur du filtre de refroidissement 4 est de 4 à 20 cm par exemple 10 cm.

Dans un autre mode de réalisation non représenté, le filtre de refroidissement en mousse métallique comporte des alvéoles formant des mailles carrées.

La structure du filtre de refroidissement 4 est étroitement liée aux dimensions de l'enveloppe métallique haute tension dans laquelle il sera installé. En effet, le filtre de refroidissement 4 crée un obstacle à l'écoulement des gaz chauds résultant de l'apparition d'un arc interne dans la cellule contenant l'appareillage haute tension. Il en résulte un saut de pression à travers ce filtre de refroidissement qui induit une augmentation de la pression dans l'enveloppe haute tension en amont du filtre. Or, la pression résultante doit rester dans la limite structurelle de l'enveloppe métallique. Si la résistance à l'écoulement est trop faible, l'effet thermique ne sera pas significatif. Aussi, les dimensions du filtre de refroidissement selon l'invention sont-elles définies en tenant compte des deux situations suivantes:
- Dans le cas où l'arc interne survient loin du filtre de refroidissement 4 et près du fond de l'enveloppe métallique, le premier pic de pression dans le compartiment d'arc n'est pas influencé par le filtre de refroidissement 4. En effet, il faut plus de 10ms pour que l'onde de pression atteigne le filtre de refroidissement 4 et revienne à la zone d'arc. La puissance de l'arc chute après avoir atteint un pic au bout de 10ms. Les dimensions du filtre de refroidissement 4 sont donc calculées de manière à limiter l'augmentation de pression due au filtre de refroidissement 4, au même niveau que le premier pic de pression qui aurait été observé au sein de l'enveloppe métallique, en l'absence du filtre de refroidissement 4.
- Dans le cas où l'arc interne survient près du filtre de refroidissement 4, l'impact de ce dernier sur l'augmentation de la pression est négligeable. En effet, bien que le passage des gaz à travers le filtre de refroidissement 4 accélère l'élévation de la pression dans l'enveloppe métallique, cette pression baisse considérablement en quelques millisecondes lorsque les gaz chauds atteignent le filtre de refroidissement 4 du fait qu'elle est directement proportionnelle à la densité du gaz. Ce phénomène rend l'augmentation de pression due au filtre de refroidissement 4 presque négligeable au bout de quelques millisecondes.

Le dispositif selon l'invention permet de:
- ralentir la vitesse de gaz dans une enveloppe métallique contenant un appareillage HT ou dans un volume insuffisant de détente situé en aval de l'enveloppe métallique ;
- refroidir la température de ces gaz et créer des turbulences à l'intérieur de l'enveloppe métallique, ou du volume aval ;
- contenir la combustion des gaz inflammables à l'intérieur de l'enveloppe métallique, ou du volume aval ;
- atteindre ces objectifs sans augmenter les pics de pression dans l'enveloppe métallique, ou dans le volume aval.

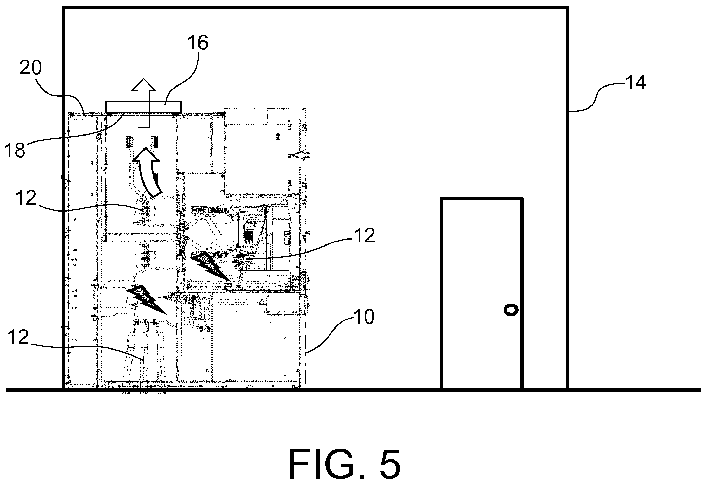

Les figures 5 à 7 représentent schématiquement une enveloppe métallique 10 contenant un appareillage haute tension 12 agencée dans une salle électrique 14.

Sur la figure 5, un filtre de refroidissement 16 est agencé sur un orifice 18 percé sur la face supérieure 20 de l'enveloppe 10 de manière à refroidir et à diminuer la vitesse d'évacuation des gaz chauds dans la salle 14.

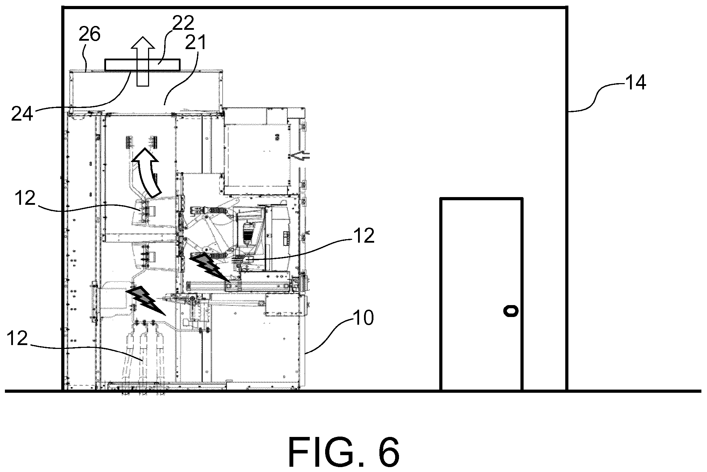

La figure 6 représente un autre mode de réalisation d'un filtre de refroidissement qui diffère du filtre de la figure 5 en ce qu'un volume tampon supplémentaire 21 est agencé au-dessus de la cellule contenant l'appareillage haute tension, en particulier pour limiter la pression, notamment, dans des cellules de hautes performances (40-50 kA). Un filtre de refroidissement 22 est agencé sur un orifice 24 percé sur la face supérieure 26 de l'enveloppe 10.

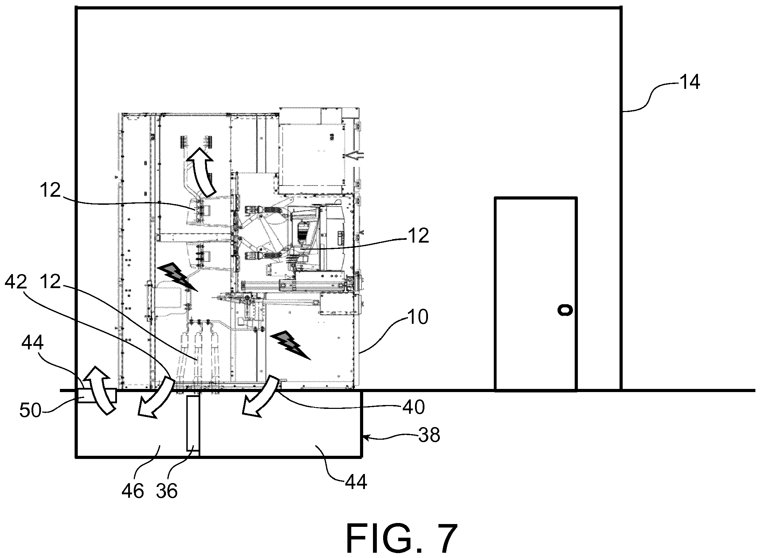

Sur la figure 7, un filtre de refroidissement 36 est agencé dans une cavité de détente 38 sous la salle électrique 14. Les gaz chauds générés dans l'enveloppe métallique 10 s'évacuent vers la cavité de détente 38 via un premier orifice 40 et un deuxième orifice 42. Le filtre de refroidissement 36 partage la cavité de détente 38 en deux zones 44 et 46. Un deuxième filtre de refroidissement 48 est agencé sur un troisième orifice 50 reliant la deuxième zone 46 et l'intérieur de la salle électrique 14.

Le filtre de refroidissement 36 ralentit le flux d'air chaud qui s'évacue par l'orifice 40 vers la première zone 44 tandis que le filtre de refroidissement 48 ralentit le flux d'air chaud qui s'évacue par l'orifice 44 de la deuxième zone 46 vers l'intérieur de la salle électrique 14.

## Revendications

1. Dispositif de refroidissement de gaz chauds générés par un arc interne dans un appareillage haute tension (12) sous enveloppe métallique (10), comportant un filtre de refroidissement (4, 16, 22, 28, 36, 48) en mousse métallique, **caractérisé en ce que** la mousse métallique a une structure en nid d'abeille comportant des alvéoles reliées de sorte à présenter des ouvertures dans toutes les directions.

2. Dispositif selon la revendication 1 dans lequel lesdites alvéoles sont sphériques.

3. Dispositif selon la revendication 1 dans lequel lesdites alvéoles forment des mailles hexaédriques.

4. Dispositif selon la revendication 1 dans lequel lesdites alvéoles forment des mailles carrées.

5. Dispositif selon la revendication 3 dans lequel lesdites alvéoles hexaédriques ont un diamètre se situant entre 1 à 4 cm.

6. Dispositif selon l'une des revendications 1 à 5 dans lequel ledit filtre de refroidissement (4, 16, 22, 28, 36, 48) est en aluminium.

7. Dispositif selon l'une des revendications 1 à 6 dans lequel ledit filtre de refroidissement (4, 16, 22, 28, 36, 48) est en fonte.

## Patentansprüche

1. Vorrichtung zur Kühlung von heißen Gasen, die durch einen inneren Lichtbogen in einer Hochspannungseinrichtung (12) in einem metallgekapselten Gehäuse (10) erzeugt werden, enthaltend einen Kühlfilter (4, 16, 22, 28, 36, 48) aus Metallschaum,
**dadurch gekennzeichnet, dass**
der Metallschaum eine Wabenstruktur aufweist, die Zellen enthält, die so verbunden sind, dass sie Öffnungen in allen Richtungen aufweisen.

2. Vorrichtung nach Anspruch 1,
wobei die Zellen kugelförmig sind.

3. Vorrichtung nach Anspruch 1,
wobei die Zellen hexaedrische Maschen bilden.

4. Vorrichtung nach Anspruch 1,
wobei die Zellen quadratische Maschen bilden.

5. Vorrichtung nach Anspruch 3,
wobei die hexaedrischen Zellen einen Durchmesser im Bereich von 1 bis 4 cm haben.

6. Vorrichtung nach einem der Ansprüche 1 bis 5,
wobei der Kühlfilter (4, 16, 22, 28, 36, 48) aus Aluminium besteht.

7. Vorrichtung nach einem der Ansprüche 1 bis 6,
wobei der Kühlfilter (4, 16, 22, 28, 36, 48) aus Gusseisen besteht.

## Claims

1. Device for cooling hot gases generated by an internal arc in high voltage metal-enclosed (10) switchgear and controlgear (12), comprising a metal foam cooling filter (4, 16, 22, 28, 36, 48), **characterized in that** the metal foam has a honeycomb structure comprising cells connected together so as to have openings in all directions.

2. Device according to claim 1 in which said cells are spherical.

3. Device according to claim 1 in which said cells form hexahedral meshes.

4. Device according to claim 1 in which said cells form square meshes.

5. Device according to claim 3 in which said hexahedral cells have a diameter lying between 1 and 4 cm.

6. Device according to any of claims 1 to 5 in which said cooling filter (4, 16, 22, 28, 36, 48) is made of aluminium.

7. Device according to any of claims 1 to 6 in which said cooling filter (4, 16, 22, 28, 36, 48) is made of cast iron.
